Europäisches Patentamt

European Patent Office

Office européen des brevets

(19)

(11) Publication number: **0 024 923**
**B1**

(12) **EUROPEAN PATENT SPECIFICATION**

(45) Date of publication of patent specification: 04.04.84

(51) Int. Cl.³: **H 01 L 29/72**

(21) Application number: 80302976.8

(22) Date of filing: 28.08.80

(54) Transistor structure.

(30) Priority: 29.08.79 JP 109906/79

(43) Date of publication of application:
11.03.81 Bulletin 81/10

(45) Publication of the grant of the patent:
04.04.84 Bulletin 84/14

(84) Designated Contracting States:
DE FR GB IT NL

(56) References cited:
WO - A - 79/00736
DE - A - 2 241 306
US - A - 3 902 188

ELECTRONIC DESIGN, vol. 27, no. 7, March
29th, 1979, Rochelle Park, US, D. BAUGHER et
al.: "To pick the right power semiconductor,
understand device processing methods", pages
142-147

PATENTS ABSTRACTS OF JAPAN, vol. 3, no.
89, 28th July 1979, page 64 E 126, Tokyo, JP

(73) Proprietor: FUJITSU LIMITED
1015, Kamikodanaka Nakahara-ku
Kawasaki-shi Kanagawa 211 (JP)

(72) Inventor: Nawata, Yoshiaki
2-1-25-501, Yohkohdai Isogo-ku
Yokohama-shi Kanagawa 235 (JP)

(74) Representative: Overbury, Richard Douglas et al,
HASELTINE LAKE & CO Hazlitt House 28
Southampton Buildings Chancery Lane
London WC2A 1AT (GB)

Courier Press, Leamington Spa, England.

## Transistor Structure

This invention relates to a transistor structure, and more particularly to a structure of a high output power transistor comprised of a plurality of transistor units formed on a single semiconductor substrate and connected in parallel with each other, each of said transistor units having a stabilizing resistor inserted in the emitter circuit thereof.

To improve characteristics in the high frequency range and yet obtain a higher output power, there have been developed and put into practical use, various transistors which comprise a plurality of transistor units formed on a single semiconductor substrate and connected in parallel with each other, such as overlay transistors, mesh-emitter transistors, ring-emitter transistors and emitter-ballast transistors. In the transistors of these types, however, all transistor units comprising a transistor do not always have equal electrical characteristics. It will, therefore, be appreciated that, when the transistor units connected in parallel to each other are placed in operation, some of the units may be subjected to overload causing a secondary breakdown thereof. To prevent such secondary breakdown, stabilizing resistors are inserted in respective emitter circuits of the transistor units in the transistors of the aforementioned types, to effect negative feedback operation in the respective transistor unit so that the load applied to the transistor units will be uniform.

Various methods have been heretofore proposed for inserting the stabilizing resistor into the emitter circuit of the transistor unit. In a first method, a resistive material (e.g. a metal such as a Nichrome (Ni-Cr), polycrystalline semiconductor, etc) is deposited in a desired thickness at an electrode window formed on an insulation layer covering the surface of the emitter region of the transistor unit. Then, an electrode is provided at one end of the deposited resistive material, so that a stabilizing resistor is inserted into the emitter circuit. In this case, if a desired resistance value cannot be attained by the stabilizing resistor formed by depositing the resistive material in the electrode window, the resistive material may be deposited so that it extends along the insulation layer.

Another method is such that, when emitter regions are formed in a base region, additional diffused regions, of the same conductivity type as that of the emitter regions, are formed simultaneously within the base region in a predetermined shape, and the diffused regions act as stabilizing resistor regions. These resistor regions may also be formed in a separate step from the step for forming the emitter regions. In case the stabilizing resistors are formed in accordance with this method, each of the diffused resistor regions may be so disposed that it may be in contact at one of its ends with a corresponding emitter region and connected at its other end to an electrode wire; or it may be isolated from the corresponding emitter region and connected at one of its ends to said emitter region through an electrode wire and at its other end to another electrode wire.

The above mentioned previously proposed methods, however, involve such disadvantages as the number of steps for fabrication is increased, it is difficult to provide a device of excellent electrical properties and it is quite difficult to increase the integration density of transistor units. That is, in the former method, the number of fabrication steps is increased because steps are required for depositing and patterning the resistive material. In addition, where the number of the emitter regions is increased to obtain a higher output power, it becomes difficult to effect patterning because the area of each individual emitter region is reduced. Therefore, if the number of emitter regions is increased, it is difficult to increase the integration density and the chip size of the semiconductor device will be increased. Furthermore, the method in which a resistor is deposited using a suitable resistive material has not been reduced to practical use yet because it is difficult to find appropriate resistive materials which can satisfy both the resistance and the current capacity requirement.

On the other hand, in the latter method, in which the diffused resistor region formed in the base region and having the same conductivity type as that of the emitter region is used as a stabilising resistor, the region insulated by a P—N junction from the base region is used, in effect, as the stabilizing resistor. It is, therefore, easy to provide the stabilizing resistor. However, since the conductivity type of the diffused resistor region acting as the stabilizing resistor is the same as that of the emitter region, carrier injection from the diffused resistor region to the base region from the diffused resistor region to the base region occurs during the operation of the transistor. As a result, this method has a disadvantage that the current amplification factor is lowered.

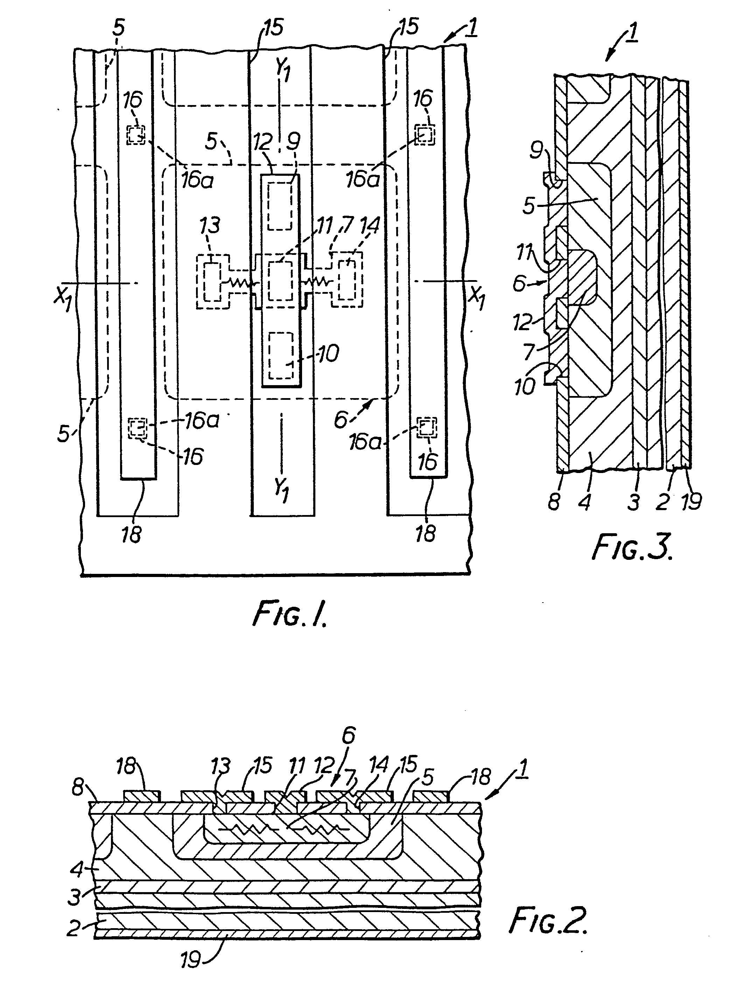

In the light of the background mentioned above, the inventors of this invention have proposed a transistor as illustrated in Fig. 1 to Fig. 3 of the accompanying drawings which are, respectively, a plan view to an enlarged scale of part of such a transistor, a cross-sectional view taken along the line $X_1$—$X_1$ of Fig. 1, and a sectional view taken along the line $Y_1$—$Y_1$ of Fig. 1.

Fig. 1 illustrates, in an enlarged scale, a part of a transistor as previously proposed. The transistor 1 has, as illustrated in Fig. 2, a collector region 3 provided on an N-type semiconductor silicon substrate 2 in the form of an N-type epitaxial layer, a P-type base region 4 formed contiguously to said collector region 3, and a number of $N^+$-type emitter regions 5 formed in said base region 4. Although only one emitter region 5 is illustrated in Fig. 2, a plurality of emitter regions 5 are arranged in a matrix structure within the base region 4 and each of the emitter regions 5 forms a transistor unit 6 in combination with the base region 4 and the collector region 3 as can be seen from Fig. 1. Each emitter region 5 has a resistor region 7 acting as a stabilizing resistor and provided in the form of a $P^+$-type diffused region which is formed in the emitter region by effecting selective diffusion of suitable acceptor impurities. Thus, the resistor region 7 is isolated from the base region 4 by the emitter region 5, thereby effectively preventing unnecessary carrier injection from the resistor region 7 to the base region 4. Other transistor units are also provided with resistor regions, respectively, as in the transistor unit 6 illustrated. As a result, in each transistor unit, lowering of the current amplification factor which may possibly be caused by the provision of the stabilizing resistor can be prevented.

As depicted in Fig. 1, the resistor region 7 is formed in an elongated shape and is so disposed that a line extending along the length of said resistor region 7 may intersect a line defining the location of the emitter region. In this embodiment, the resistor region 7 is formed in such a way that the line extending along the length of the resistor region intersects a line defining the location of the emitter region at a right angle. A surface of the so constructed semiconductor substrate 2 is covered with an insulation layer 8 (Fig. 2) such as a silicon oxide layer. On the insulation layer 8 there are provided metal layers for wiring, as well as windows for connecting the metal layers to desired regions. More particularly, two windows 9 and 10 (Fig. 1) are formed on the insulation layer 8 at portions thereof confronting the emitter region 5, in such a manner that they are disposed along a line perpendicular to a line extending along the length of the resistor region 7, and; a window 11 is formed on the insulation layer 8 at a portion thereof confronting the resistor region 7, so as to be aligned with said windows 9 and 10. The emitter region 5 and the resistor region 7 are connected to each other through these windows 9, 10 and 11 by means of a metal layer 12 provided on the insulation layer 8 (see Fig. 3). A similar connection is provided in each of other transistor units. Windows 13 and 14 are further provided at end portions of the resistor region 7. In other transistor units, windows corresponding to said windows 13 and 14 are similarly provided on the insulation layer 8. Then, as can be understood from the foregoing description, the windows 13 and 14 of the respective transistor units are also arranged in a matrix formation. The resistor regions exposed through the respective windows 13 and 14 are connected by a plurality of common emitter electrodes 15, each provided on the insulation layer 8 so as to be at right angles with a line extending along the length of the resistor region 7. That is, the emitter regions of the respective transistor units are commonly connected by the emitter electrodes 15 through the resistor regions provided in the corresponding emitter regions, respectively. The construction of the transistor shown in Figs. 1 to 3 has the feature that the major face of the respective emitter region 5 is formed generally in a rectangular shape and that base contact regions 16 are disposed on diagonal lines of the region 5. In the figures, the numeral 18 designates base electrodes. The base electrodes 18 are connected to the respective base contact regions 16 by way of windows 16a formed on the insulation layer 8 facing to the respective base contact regions 16. The number 19 denotes a collector electrode. When the transistor unit is in operation, the greater part of the periphery of the emitter region 5 serves to flow a large current.

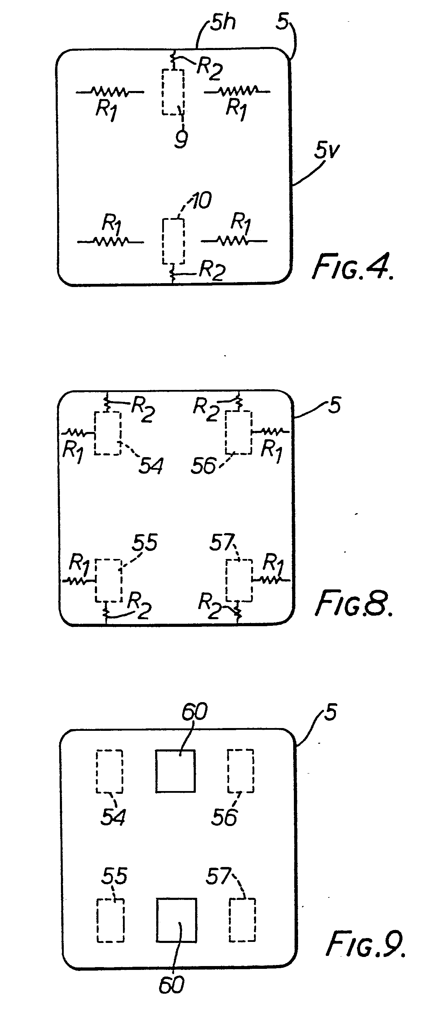

A transistor as illustrated in Figs. 1 to 3 has proved, however, to allow non uniform flow of current in the emitter regions in operation with a large current, which results in a fall in current amplification factor and an increase of saturation voltage $V_{CE(sat)}$ etc. This is because the distance from the locations of the contact areas in the windows 9, 10 deposited in an emitter region to the emitter-base junctions respectively neighbouring those windows is not uniform around the entire circumference of the emitter region and the resistance effective between the contact areas and the circumference of the emitter region also varies. Namely, in regard to the distance between the windows disposed in the emitter region 5 and the circumference (the emitter-base junction) of the emitter region, as indicated in Fig. 4 of the accompanying drawings, which is a schematic plan view of an emitter region 5, the distance from the contact areas to the vertical edge 5v (vertical as seen in Fig. 4) of the emitter region is greater than that from the contact areas to the horizontal edge 5h (horizontal as seen in Fig. 4) of the emitter region. The resistance $R_1$ between such contact areas and edge 5v, therefore, is larger than the resistance $R_2$ between said contact areas and the edge 5h.

For this reason, when a current flows through such emitter region, a current tends to flow generally in the centre portion of edge 5h and therefore uniform operation is not provided around the entire circumference of the emitter region. Therefore, as mentioned above, nonuniform flow of current results in a reduction of current amplification factor and increase of saturation voltage.

Our European Patent Application No. 80301150.1, published on 26th November 1980 under publication No. 0 019 355 and falling under Article 54 (3) EPC, discloses a transistor structure comprising a collector region of one conductivity type, a base region of the opposite conductivity type, contiguous to the collector region, and a plurality of small active emitter regions all of the said one conductivity type, formed within the base region, wherein stabilizing resistor elements are formed within the small active emitter regions, and an emitter electrode strip is provided which is commonly connected to central portions of the stabilizing resistor elements, and conducting means are disposed to respective opposite sides of the emitter electrode strip, substantially parallel thereto, for electrically connecting each resistor element to a respective emitter region.

It is mentioned in our European Patent Application No. 80301150.1 that a stabilizing resistor can be formed within an emitter region of the said one conductivity type as a region of the opposite conductivity type. It is also mentioned that a stabilizing resistor can consist of semiconductor material on an insulation layer for different emitter geometries.

It is disclosed that the conducting means can be connected to a small active emitter region at a plurality of places within the small active emitter region.

It is also disclosed that the conducting means can electrically connect respective opposite end portions of each resistor element to areas along respective edges of the respective small active emitter region, the small active emitter regions of the plurality being of rectangular type.

In the transistor structure of our European Patent Application No. 80301150.1 a strip or stripe-like emitter region, formed on a base region, is divided into a number of small active emitter regions, each forming part of a respective transistor unit. The small active emitter regions are isolated from one another by isolation regions formed in the strip or stripe-like emitter region or by the stabilizing resistors of the transistor units themselves. The isolation regions, or the stabilizing resistors, do not extend completely through the depth of the stripe or stripe-like emitter region and neither do they extend completely across the strip or stripe-like emitter region. Electronic Design, Vol. 27, No. 7, 29 March 1979, page 142, mentions the employment of ballasting resistors in series with multiple emitters to provide voltage drops proportional to emitter current.

According to the present invention there is provided a transistor structure, comprising:—

a collector region of one conductivity type;

a base region of the opposite conductivity type, contiguous to the collector region;

a plurality of emitter regions all of the said one conductivity type, formed within the base region;

stabilizing resistor elements formed in respective emitter regions;

an emitter electrode strip commonly connected to the stabilizing resistor elements; and

conducting means connecting each stabilizing resistor element to a respective emitter region; in which transistor structure the emitter regions of the plurality are formed as separate islands within the base region and are rectangular or octagonal, the emitter electrode strip is connected to central portions of the stabilizing resistor elements, and the stabilizing resistor elements are connected to emitter areas in the vicinities of corners of the emitter regions by the conducting means, which are arranged substantially parallel to the emitter electrode strip on opposite sides of the strip.

The present invention can provide a transistor wherein a plurality of emitter units each respectively having a stabilizing resistor are integrated and each emitter unit operates effectively.

The present invention can provide a structure wherein stabilizing resistors are disposed so as to operate almost uniformly the circumference of each emitter region in a transistor where a plurality of emitter units each respectively having a stabilizing resistor are integrated.

Briefly, an embodiment of the present invention provides a transistor comprising, on a substrate, a collector region of one conductivity type, a base region of the opposite conductivity type contiguous to the collector region, and an emitter region of the one conductivity type formed within the base region which transistor comprises a resistor formed within the emitter region to act as stabilizing resistor, an emitter electrode which is connected to the resistor, and conducting means for connecting the resistor to the emitter regions which are disposed in both sides of said emitter electrode.

Reference is made, by way of example, to the accompanying drawings, in which:—

Figure 1 is, as mentioned above, a plan view to an enlarged scale of part of a transistor previously proposed;

Figure 2 is a cross-sectional view taken along the line $X_1$—$X_1$ of Fig. 1;

Figure 3 is a cross-sectional view taken along the line $Y_1$—$Y_1$ of Fig. 1;

Figure 4 is a schematic plan view of an emitter region of the transistor of Fig. 1 indicating resistances between electrode windows and the circumference of an emitter region in the transistor;

Figure 5 is a plan view to an enlarged scale of part of a transistor embodying the present invention;

Figure 6 is a cross-sectional view taken along the line $X_5$—$X_5$ of Fig. 5;

Figure 7 is a cross-sectional view taken along the line $Y_5$—$Y_5$ of Fig. 5;

Figure 8 is a schematic plan view of an emitter region of the transistor of Fig. 1 indicating resistances between electrode windows and the circumference of an emitter region in the transistor;

Figure 9 is a schematic plan view similar to that of Fig. 8 but relating to a partly modified version of the transistor of Fig. 5;

Figure 10 is a plan view to an enlarged scale of part of another transistor embodying the present invention;

Figure 11 is a plan view to an enlarged scale of a further transistor embodying the present invention;

Figure 12 is a plan view to an enlarged scale of still another transistor embodying the present invention; and

Figure 13 is a cross-sectional view taken along the line $X_{12}$—$X_{12}$ of Fig. 12.

Referring now to the accompanying drawings, there are illustrated preferred embodiments of the present invention.

Fig. 5 illustrates, in an enlarged scale, a part of a transistor in accordance with the present invention. The transistor 1 has, as illustrated in Fig. 6, a collector region 3 provided on an N-type semiconductor silicon substrate 2 in the form of an N-type epitaxial layer, a P-type base region 4 formed contiguously to said collector region 3, and a number of N$^+$-type emitter regions 5 formed in said base region 4. It will be seen that the emitter region 5 illustrated in Figs. 5 to 7 is formed as an island in the base region 4. Although only one emitter region 5 is illustrated in Figs. 5 to 7, a plurality of emitter regions 5 are arranged in a matrix structure within the base region 4 and each of the emitter regions 5 forms a transistor unit 6 in combination with the base region 4 and the collector region 3 as can be seen from Fig. 5. Each emitter region 5 has a resistor region 7 acting as a stabilizing resistor and provided in the form of a P$^+$-type diffused region which is formed in the emitter region by effecting selective diffusion of suitable acceptor impurities. Thus, the resistor region 7 is isolated from the base region 4 by the emitter region 5, thereby effectively preventing unnecessary carrier injection from the resistor region 7 to the base region 4. Other transistor units are also provided with resistor regions, respectively, as in the transistor unit illustrated. As a result, in each transistor unit, lowering of the current amplification factor which may possibly be caused by carrier injection from the resistor region to the base region can be prevented.

As depicted in Fig. 5, the resistor region 7 is formed in an elongated shape and is so disposed that a line extending along the length of said resistor region 7 may intersect a line defining the location of the emitter region. A surface of the so constructed semiconductor substrate 2 is covered with an insulation layer 8 (Fig. 6) such as a silicon oxide layer. On the insulation layer 8 there are provided metal layers for wiring, as well as windows for connecting the metal layers to desired regions.

The construction of the transistor shown in Figs. 5 to 7 has the feature that the major face of an emitter region 5 is formed generally in a rectangular shape and that base contact regions 16 are disposed along diagonal lines across the region 5. In the figures, the numeral 18 designates base electrodes. The electrodes 18 are connected to the respective base contact regions 16 by way of windows 16a formed on the insulation layer 8 facing to the respective base contact regions 16. The number 19 denotes a collector electrode.

In the transistor of Figs. 5 to 7, an emitter electrode or electrode strip 51 is deposited on the one emitter region 5 shown completely in Fig. 5 so as to cross over substantially a central portion of the emitter region 5. The emitter electrode is connected to a contact area provided in a window 11 centrally of stabilizing resistor 7. Metal layers 52, 53 connect the stabilizing resistor 7 and the emitter region 5. The layers 52, 53 are deposited to opposite ends of the stabilizing resistor 7, namely on opposite sides of the emitter electrode 51. The metal layer 52 is connected to the stabilizing resistor 7 in a window 13 and also connected to the emitter region 5 in windows 54 and 55 (see Fig. 7). The metal layer 53 is connected to stabilizing resistor 7 in a window 14 and also connected to the emitter region 5 in windows 56 and 57.

Thus, the metal layers 52 and 53 which connect the stabilizing resistor 7 and the emitter region 5 are connected to the emitter region at the four points within the emitter region, and more particularly are connected at areas near the corners of the emitter region 5. It will be seen that the metal layers 52 and 53 extend substantially parallel to the strip 51.

As shown in Fig. 8, according to the electrode connecting structure as explained above, the distances between the contact areas formed in the windows 54, 55, 56, 57 and the circumference of the emitter region 5 are all almost equal. That is, the vertical and horizontal distances from a window to the part of the circumference of the emitter region located in the area of the window are approximately the same for each window. Therefore, resistance values $R_1$ and $R_2$ become almost equal, and moreover, of lower value as compared with the values of Fig. 5. Thus current is not concentrated, during operation, in a specific part of the circumference of the emitter region in a transistor having the electrode connecting structure as mentioned above. This can provide for the maintenance of current amplification factor and an increase in saturation voltage.

In such a structure as illustrated in Figs. 5 to 8, when windows 54, 55, 56, 57 have a rectangular shape, the distance between the longer window side and the confronting part of the circumference of the emitter region may be greater than the distance between the shorter window side and the confronting part of the circumference of the emitter region.

Moreover, since the emitter region just below the emitter electrode 51 is comparatively far from any of the windows 54, 55, 56, 57 and is comparatively inactive, an opening portion 60 can be provided in the emitter region 5 as shown in Fig. 9. Thereby concentration of current during turn-off may be prevented and thereby breakdown of the emitter region may also be prevented.

A transistor comprised of transistor units as specified above may be prepared in the manner as mentioned hereinbelow.

The collector region 3 may be provided by forming an N-type semiconductor layer on an $N^+$-type silicon semiconductor substrate 2 in accordance with an epitaxial growth method; or by a method comprising, first, forming $N^+$-type semiconductor layers on the opposite sides of an N-type semiconductor substrate by diffusing donor impurities, at a high concentration, from the surfaces of said semiconductor substrate and, then, removing one of the $N^+$-type semiconductor layers formed on either side of said N-type semiconductor substrate.

The P-type base region may be provided by selectively or nonselectively diffusing acceptor impurities such as boron, etc., into the substrate. In this case, if the desired transistor is a transistor to be used in a high-voltage condition, it is preferred to employ a so-called mesa structure in which the base-collector junction appears on a side of the chip. On the other hand, if the desired transistor is a transistor to be used in a low-voltage condition, a planar structure is preferably employed.

The base contact region may be provided by a method wherein acceptor impurities are selectively diffused into the aforementioned P-type base region to form a region where the impurity concentration is higher than at the base region.

The $N^+$-type emitter regions may be provided by selectively diffusing donor impurities, e.g., arsenic (As), phosphorus (P), etc., at a high concentration into the base region.

The $P^+$-type resistor region may be provided by selectively diffusing acceptor impurities at a high concentration into the emitter regions. In this connection it is to be noted that, since it is not required that the value of the diffusion depth at the base contact regions be a precise predetermined value, the base contact regions may be formed simultaneously with the formation of the resistor regions where the value of the depth is to be regulated.

There may be mentioned as an example of a suitable insulation layer, a layer of silicon dioxide ($SiO_2$) formed by thermal oxidation or vapour growth. Silicon dioxide may be also employed in combination with silicon nitride ($Si_3N_4$), phospho-silicate glass (PSG), etc.

The emitter wiring electrodes, the base wiring electrode and the metal layers may be formed by evaporating aluminium, and then, effecting patterning so as to remove unnecessary portions. These wiring electrodes and metal layers are electrically connected to desired regions, respectively, through the windows formed in the insulation layer.

When the resistor region is formed in the emitter region according to the method mentioned above, if the depth of the emitter region is not sufficient, the depth of the emitter region will be increased to exceed the predeterminted value due to the so-called "emitter dip effect". Consequently, the emitter-to-base breakdown voltage and the emitter-to-collector breakdown voltage may possibly be lowered and it might be difficult to obtain a large current amplification factor. The following are suggested to minimize the influence of the "emitter dip effect".

(1) The thickness of the base region is preliminarily increased selectively at a portion corresponding to the portion where the resistor region is formed, so that the required width of the base region may be maintained even if the emitter region is caused to dip due to formation of the resistor region.

(2) The emitter region is preliminarily so formed that it may have a decreased thickness and lower impurity concentration selectively at a portion corresponding to the portion where the resistor region is formed, whereby the portion caused to dip by forming the resistor region is cancelled or compensated for.

(3) After forming the base region, etching is effected so that the semiconductor substrate is protruded at a portion thereof corresponding to the portion where the resistor regions are to be formed. After this process diffusion is effected for shaping emitter regions. Thus the emitter region has a portion under the protruded portion which has less depth than the remaining portion of the emitter region which is formed simultaneously on the peripheral planar portion, so that a dipped portion produced during the formation of the resistor region is cancelled or compensated for.

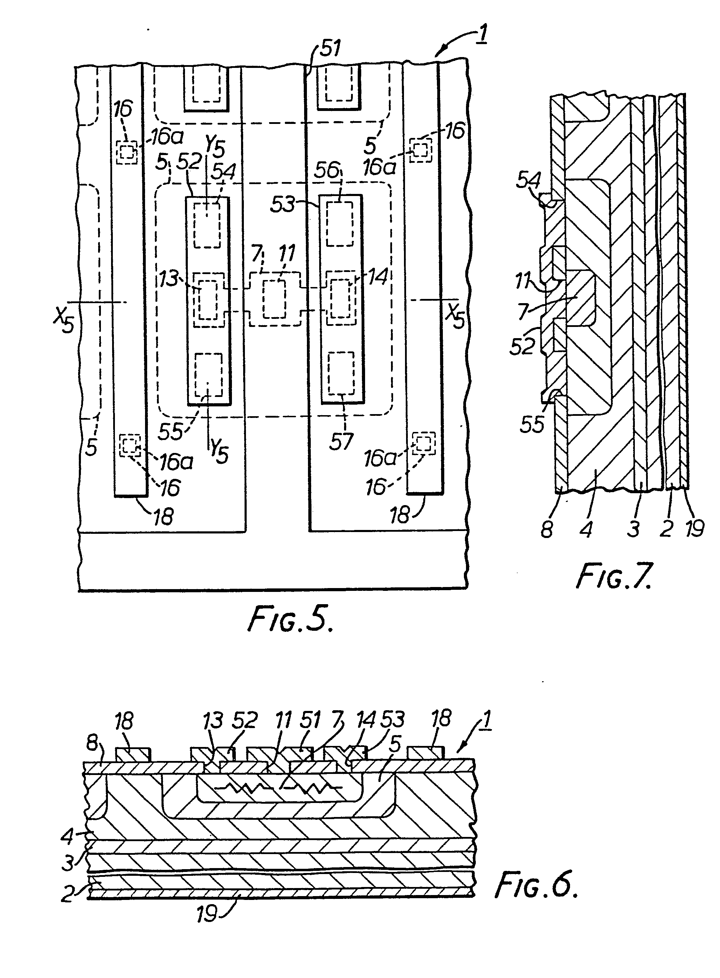

Figure 10 shows another embodiment of the present invention. In this Figure, portions corresponding to those in Fig. 5 to Fig. 7 are given the same reference numbers.

In the embodiment of Figure 10, in plan view the emitter region 5 is seen to be octagonal. The emitter electrode 51 is deposited so as to cross two or more confronting sides of the eight sides of the emitter region. The windows 54, 55, 56 and 57 to which the metal layers 52, 53 are connected are deposited in the areas adjacent respective corners of the octagonal emitter regions (corners which are not formed by sides crossed by the emitter electrode). Sides of the windows are almost equidistant from the sides of the emitter region adjacent thereto. In Figure 10 reference numeral 70 designates a $P^+$-type region used for base contact. In such a structure, the circumference of emitter region 5 operates more uniformly.

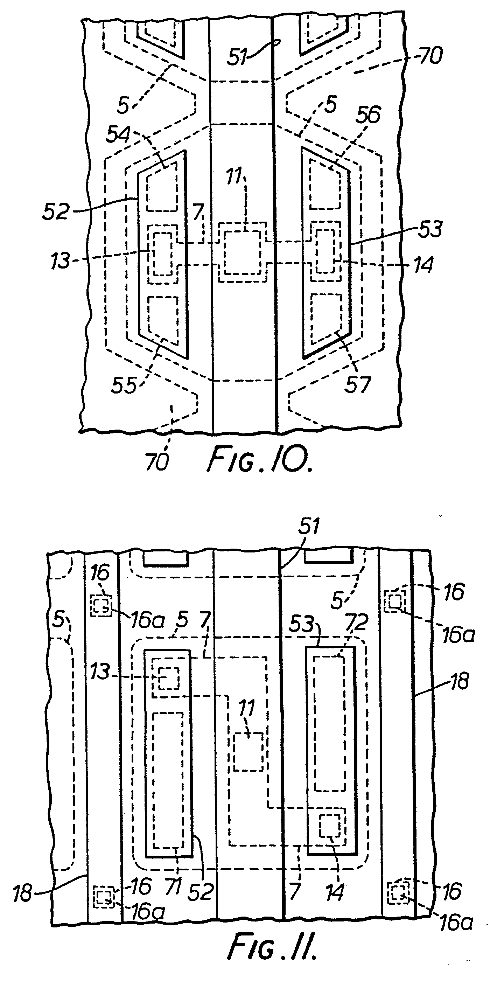

Figure 11 shows another embodiment of the present invention. In this Figure, portions corresponding to those in Fig. 5 to Fig. 7 are given the same reference numbers.

In the embodiment of Figure 11, a major part of a stabilizing resistor 7 is disposed below the emitter electrode 51 and extends in parallel thereto. Opposite ends of the stabilizing resistor 7 are connected to contact areas in comparatively large rectangular windows 71, 72 which are located along the edges of the emitter region 5 to opposite sides of said emitter electrode 51, by means of metal layers 52, 53.

By employing this structure, the circumference of emitter region confronting the contact areas in the windows 71, 72 operates effectively since the windows 71, 72 are very long and a resistance between the contact areas in the windows 71, 72 is much lowered.

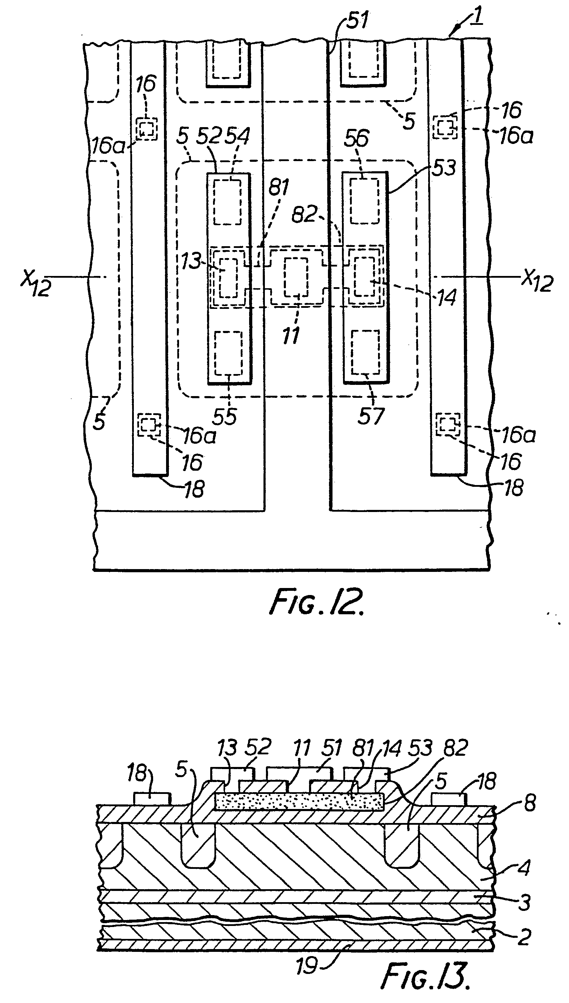

Figure 12 and Figure 13 indicate still another embodiment of the present invention. In these Figures, portions corresponding to those in Fig. 5 to Fig. 7 are given the same reference numbers.

This embodiment comprises a semiconductor layer, for example, a polycrystalline silicon layer 81, which provides a stabilizing resistance deposited on the insulating layer 8. Disposition of such a stabilizing resistor also makes possible an effective operation as in the case of other embodiments. A stabilizing resistor consisting of polycrystalline silicon layer 81 has, for example, the thickness of 2000 (Å) and resistance value of 10 (Ohms).

In this embodiment, an opening portion 82 is preferably provided at the centre of the emitter region 5 just below the stabilizing resistor 81 in order to prevent concentration of current to the central portion of said emitter region 5 during turn-off and resultant secondary breakdown thereof.

It will be seen that in the embodiments of Figures 10, 11 and 12 the emitter regions 5 are formed as islands within base regions 4. It will further be seen that the metal layers 52 and 53 are to opposite sides of and substantially parallel to the emitter electrode strip 51.

## Claims

1. A transistor structure, comprising:—
a collector region (3) of one conductivity type;
a base region (4) of the opposite conductivity type, contiguous to the collector region;
a plurality of emitter regions (5) all of the said one conductivity type, formed within the base region;
stabilizing resistor elements (7) formed in respective emitter regions;
an emitter electrode strip (51) commonly connected to the stabilizing resistor elements; and
conducting means (52, 53) connecting each stabilizing resistor element to a respective emitter region; in which transistor structure the emitter regions of the plurality are formed as separate islands within the base region and are rectangular or octagonal, the emitter electrode strip is connected to central portions of the stabilizing resistor elements, and the stabilizing resistor elements are connected to emitter areas in the vicinities of corners of the emitter regions by the conducting means, which are arranged substantially parallel to the emitter electrode strip on opposite sides of the strip.

2. A transistor structure as claimed in claim 1, wherein each stabilizing resistor element is a region of the said opposite conductivity type.

3. A transistor structure as claimed in claim 1, wherein each stabilizing resistor element comprises semiconductor material disposed on an insulation layer.

4. A transistor as claimed in claim 1, 2 or 3, wherein the conducting means are connected to each emitter region at a plurality of areas within the emitter region.

5. A transistor structure as claimed in any preceding claim, wherein the conducting means electrically connect respective opposite end portions of each resistor element to areas along respective edges of the respective emitter region, the emitter regions of the plurality being rectangular.

## Patentansprüche

1. Transistorstruktur mit einer Kollektorzone (3) von einer Leitfähigkeitsart; einer an die Kollektorzone angrenzende Basiszone (4) von entgegengesetzter Leitfähigkeitsart; einer Mehrzahl von Emitterzonen (5), welche alle von der genannten einen Leitfähigkeitsart und innerhalb der Basiszone ausgebildet sind; in den entsprechenden Emitterzonen gebildeten stabilisierenden Widerstandselementen (7); einem Emitterelektrodenstreifen (51), welches mit allen stabilisierenden Widerstandselementen gemeinsam verbunden ist; und mit Leitern (52, 53), welche jedes der stabilisierenden Widerstandselemente mit einer entsprechenden Emitterzone verbinden, bei welcher Transistorstruktur die Emitterzonen als separate Inseln innerhalb der Basiszone und rechtwinklig oder oktogonal ausgebildet sind, der Emitterelektrodenstreifen mit den zentralen Abschnitten der stabilisierenden Widerstandselemente verbunden ist und die stabilisierenden Widerstandselemente mit den Emitterflächen in der Nähe der Ecken der Emitterzonen durch die Leiter verbunden sind, welche im wesentlichen parallel zu dem Emitterelektrodenstreifen auf entgegengesetzten Seiten des Streifens angeordnet sind.

2. Transistor nach Anspruch 1, bei welchem jedes stabilisierende Widerstandselement eine Zone von entgegengesetzter Leitfähigkeitsart ist.

3. Transistor nach Anspruch 1, bei welchem jedes stabilisierende Widerstandselement auf einer Isolationsschicht angeordnetes Halbleitermaterial umfaßt.

4. Transistor nach einem der Ansprüche 1, 2 oder 3, bei welchem die Leiter mit jeder Emitterzone bei einer Mehrzahl von Flächen innerhalb der Emitterzone verbunden sind.

5. Transistorstruktur nach einem der vorhergehenden Ansprüche, bei welcher die Leiter entsprechende entgegengesetzte Endabschnitte jedes Widerstandselements elektrisch mit Flächen längs entsprechenden Rändern der entsprechenden Emitterzone verbinden, wobei die mehreren Emitterzonen rechtwinklig sind.

## Revendications

1. Structure de transistor comprenant: une région de collecteur (3) d'un premier type de conductivité; une région de base (4), du type opposé de conductivité, contiguë à la région de collecteur; une pluralité de régions d'émetteur (5), toutes dudit premier type de conductivité, formées à l'intérieur de la région de base; des éléments de résistance de stabilisation (7) formées dans les régions d'émetteur respectives; une bande d'électrode d'émetteur (51) connectée en commun aux éléments de résistance de stabilisation; et des moyens conducteurs (52, 53) connectant chaque élément de résistance de stabilisation à une région d'émetteur respective; dans laquelle structure de transistor les régions d'émetteur de la pluralité se présentent sous forme d'îles séparées à l'intérieur de la région de base et sont rectangulaires ou octogonales, la bande d'électrode d'émetteur est connectée à des parties centrales des éléments de résistance de stabilisation, et les éléments de résistance de stabilisation sont connectés à des aires d'émetteur se trouvant dans le voisinage de coins des régions d'émetteur par les moyens conducteurs, qui sont disposés sensiblement parallélement à la bande d'électrode d'émetteur sur des côtés opposés de la bande.

2. Structure de transistor selon la revendication 1, où chaque élément de résistance de stabilisation est une région dudit type opposé de conductivité.

3. Structure de transistor selon la revendication 1, où chaque élément de résistance de stabilisation comprend une matière semiconductrice disposée sur une couche d'isolation.

4. Transistor selon la revendication 1, 2 ou 3, où les moyens conducteurs sont connectés à chaque région d'émetteur au niveau d'une pluralité d'aires à l'intérieur de la région d'émetteur.

5. Structure de transistor selon l'une quelconque des revendications précédentes, où les moyens conducteurs connectent électriquement des parties terminales opposées respectives de chaque élément de résistance à des aires suivant des bords respectifs de la région d'émetteur respective, les régions d'émetteur de la pluralité étant rectangulaires.

FIG.1.

FIG.3.

FIG.2.

FIG.4.

FIG.8.

FIG.9.

2

FIG.5.

FIG.7.

FIG.6.

FIG. 10.

FIG. 11.

4

FIG. 12.

FIG. 13.